# EUROPEAN PATENT APPLICATION

(11) **EP 2 068 359 A1**
(43) Date of publication of application: **10.06.2009**
(21) Application number: 07829166.3
(22) Date of filing: 27.09.2007
(51) Int. Cl.: H01L 23/473, G06F 1/20, H05K 7/20

(54) **COOLING APPARATUS**

(30) Priority: 28.09.2006 JP 2006264684
(71) Applicant: SANYO Electric Co., Ltd., Moriguchi-shi Osaka 570-8677 (JP)
(72) Inventor: TSUCHIYA, Masaki, Ota-city, Gunma 3730816 (JP)
(74) Representative: Glawe, Delfs, Moll
(86) International application number: PCT/JP2007/069428
(87) International publication number: WO 2008/041737

(57) **Abstract**

Provided is a cooling apparatus, which has its cooling abilitiy improved by liberating the thermal energy of a coolant from expansion means to the outside. The cooling apparatus (40) includes a compressor (41), a condenser (42), an evaporator (44), a capillary tube (43) and a blower fan (45). Moreover, a portion of the capillary tube (43) corresponding to that expansion means is arranged to abut against the casing, of the blower fan (45). Here, the portion of the capillary tube (43) is arranged so helically or spirally as to abut against the upper face of the casing of the blower fan (45). Thus, the heat can be dissipated from the capillary tube (43) to the casing of the blower fan (45).

## Description

### TECHNICAL FIELD

The present invention relates to a cooling device, more specifically to a cooling device used for an electronic device such as a computer.

### BACKGROUND ART

Recently, electronic devices represented by a notebook computer have remarkably progressed in high-functionalization and downsizing. The progress in the high-functionalization of a notebook computer drives speed-up and multi-functionalization of a CPU (central processing unit), thereby causing an increase in the amount of heat generated by the CPU.

Therefore, in order to suppress a rise in temperature of a CPU, a radiation fin having an excellent radiation performance is conventionally attached to a surface of the CPU and air is blowed onto the radiation fin by using a rotating air blow fan. Besides, heat is radiated by use of the radiation fin after heat transport is performed by use of a heat pipe. By taking these measures, it is possible to restrict the rise in temperature of the CPU having power consumption of about 60 W, for example, to about 70°C or below.

However, the amount of heat generated by a recent CPU is increased to about 100 W, for example, so that the above-described radiation methods using the air blow fan or the heat pipe causes a problem that the CPU is not sufficiently cooled. Moreover, even if the CPU is sufficiently cooled, there is another problem that a cooling device for cooling the CPU becomes enormous.

Other methods of suppressing the rise in temperature of the CPU include a method using a water cooling cycle and a method using a refrigeration cycle. In these methods, the CPU is cooled more efficiently than in the above-described methods using the air blow fan. Accordingly, it is possible to have a certain temperature or below in the CPU generating a large amount of heat. JP-A 2002-198478 discloses a technical matter to cool a semiconductor device by using a refrigeration cycle.

### DISCLOSURE OF THE INVENTION

In the above-described cooling technique, heat generated from an exothermic body such as a CPU is radiated to outside by condensing, expanding, evaporating and compressing a refrigerant such as chlorofluorocarbon, to cool the exothermic body. Here, there has been an understanding that expanding means such as a capillary tube having a function to expand the refrigerant is in an adiabatic state. That is, it has been understood that thermal energy is not exchanged between the refrigerant passing through the capillary tube, and the outside. For example, with reference to page 37 of "Advanced Level Standard Textbook for Refrigeration and Air Conditioning (Refrigeration Version)" published by Japan Society of Refrigeration and Air Conditioning Engineers, it is described that "enthalpy of a refrigerant does not change before and after expansion of the refrigerant." This description implies that the enthalpy of the refrigerant does not change in an expansion process. However, in an attempt to improve, even slightly, a cooling capacity of a refrigeration cycle, heat exchange between the refrigerant flowing through the expanding means and the outside cannot be ignored.

In addition, there is also a risk that the refrigerant flowing through the expanding means absorbs heat from the outside under some temperature conditions so that the cooling capacity of the refrigeration cycle is degraded. For example, suppose a case where the temperature of the refrigerant at an inlet of the capillary tube serving as the expanding means is equal to 30°C, the temperature of the refrigerant at an outlet of the capillary tube is equal to 10°C, and the temperature of the outside atmosphere (outside air) is equal to 20°C. In this case, the temperature of the refrigerant becomes lower than the outside air in the vicinity of the outlet of the capillary tube. Accordingly, if a heat insulation mechanism is not provided with the capillary tube, the thermal energy of the outside air is absorbed by the refrigerant. Therefore, it is conceivable that the enthalpy of the refrigerant is increased inside the capillary tube which is generally considered to be under a heat insulating condition, whereby the cooling capacity of the refrigeration cycle is degraded.

The present invention has been made in view of the foregoing problem. A principal object of the present invention is to provide a cooling device with an improved cooling performance. The cooling performance is improved by actively radiating thermal energy of a refrigerant from expanding means to outside.

A cooling device of the present invention is characterized by comprising compressing means for compressing a refrigerant, condensing means for radiating heat from the refrigerant compressed by the compressing means and then for liquefying the refrigerant, expanding means for expanding the refrigerant liquefied by the condensing means, and evaporating means for evaporating the refrigerant expanded by the expanding means while receiving heat from an exothermic body, and is characterized in that the thermal energy contained in the refrigerant is radiated from an entire region of the expanding means to the outside.

According to the cooling device of the present invention, the thermal energy contained in the refrigerant is radiated to the outside from the entire region of the expanding means formed of a capillary tube. Therefore, the cooling capacity of the cooling device is improved by a degree corresponding to a decrease in the enthalpy of the refrigerant in the expanding means

Moreover, when the capillary tube is allowed to contact a casing or air blowing means of an electronic device, the heat is radiated from the refrigerant inside the capillary tube to the outside through these units by means of thermal diffusion. Therefore, it is possible to further enhance the cooling capacity of the cooling device. Furthermore, with this configuration, even in the case where there is no or little air flow generated by the air blowing means, it is possible to radiate the thermal energy contained in the refrigerant from the capillary tube to the outside through the air blowing means and the like by means of thermal diffusion.

In addition, if the capillary tube is disposed in a region to which the air blowing means blow the air, the heat is radiated from the refrigerant inside the capillary tube to the outside by an effect of forced convection.

### BRIEF DESCRIPTION OF THE DRAWINGS

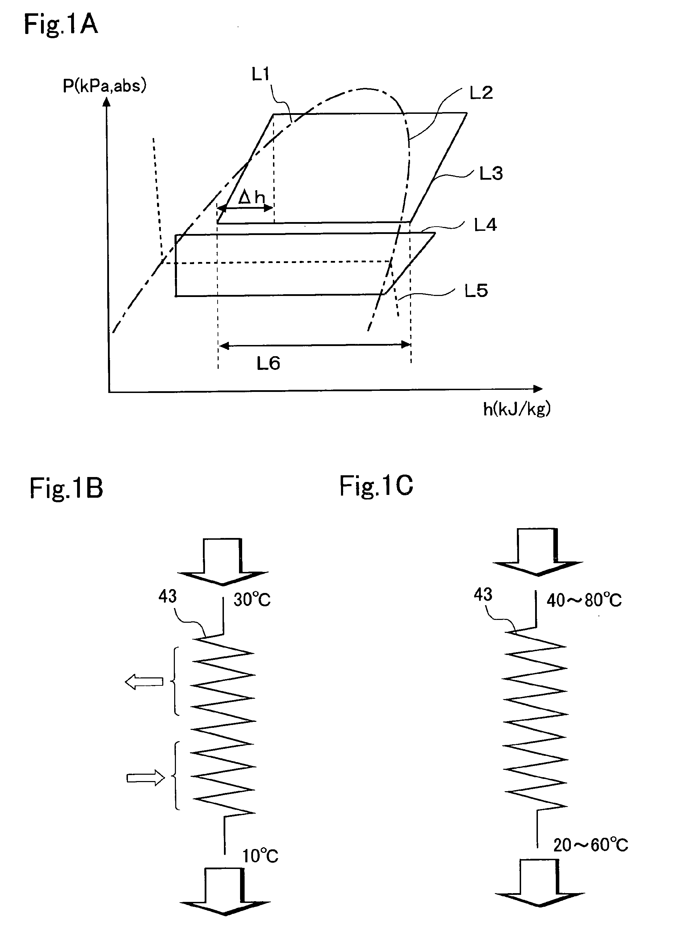

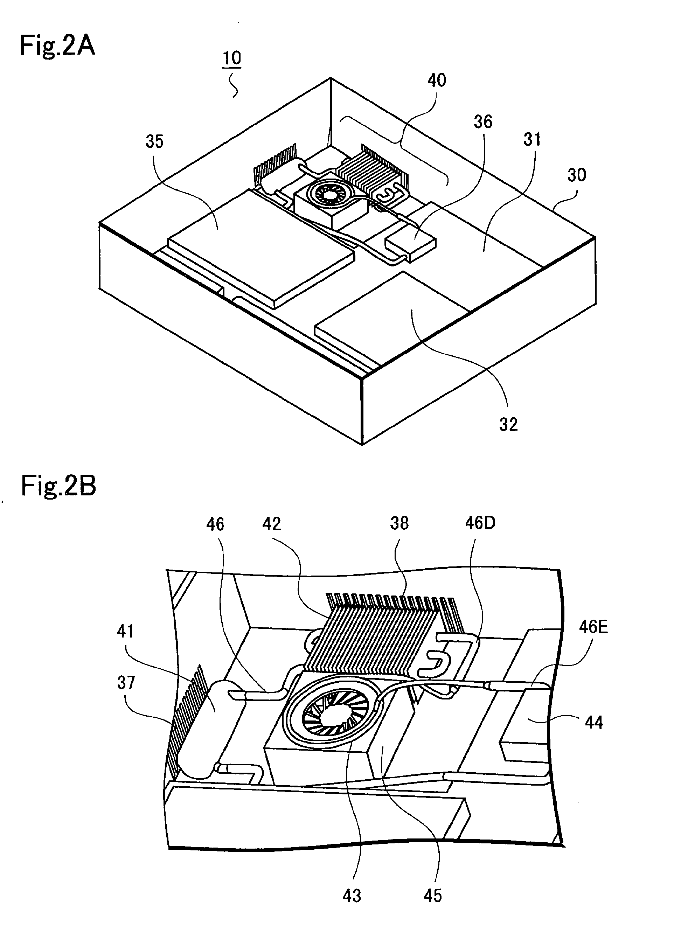

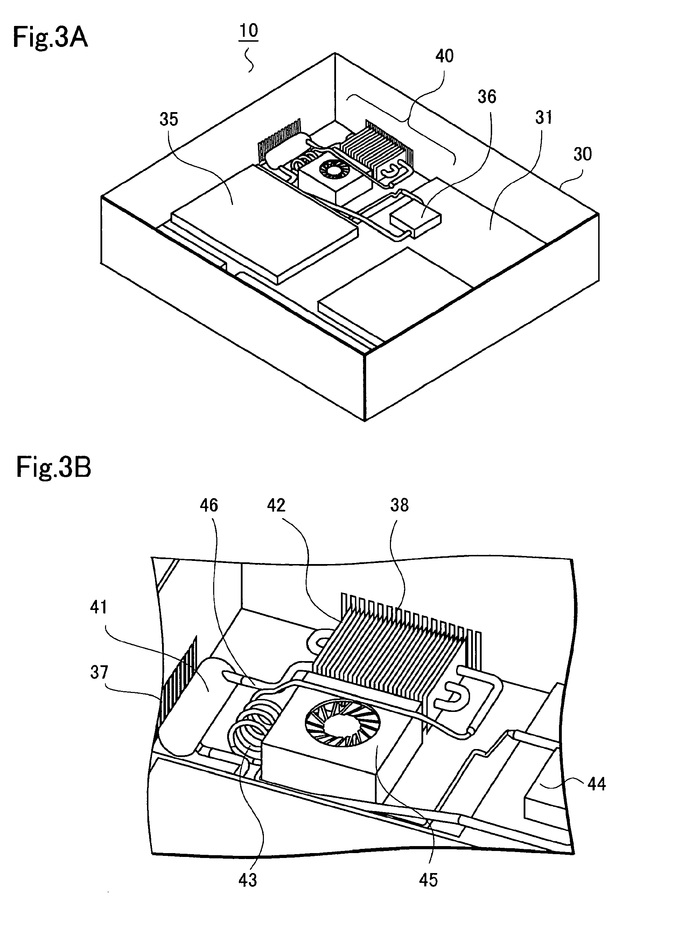

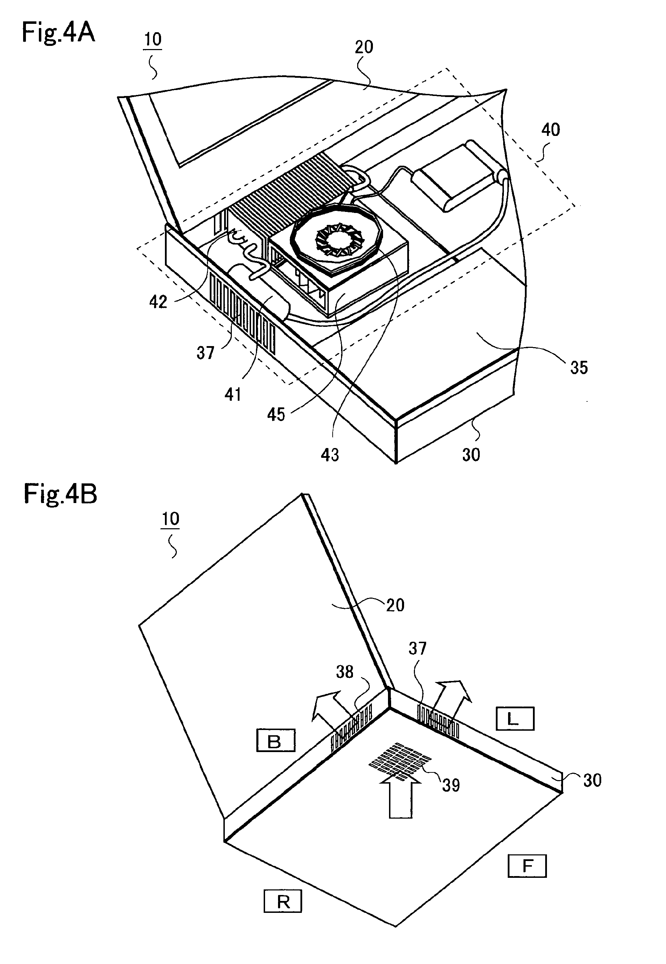

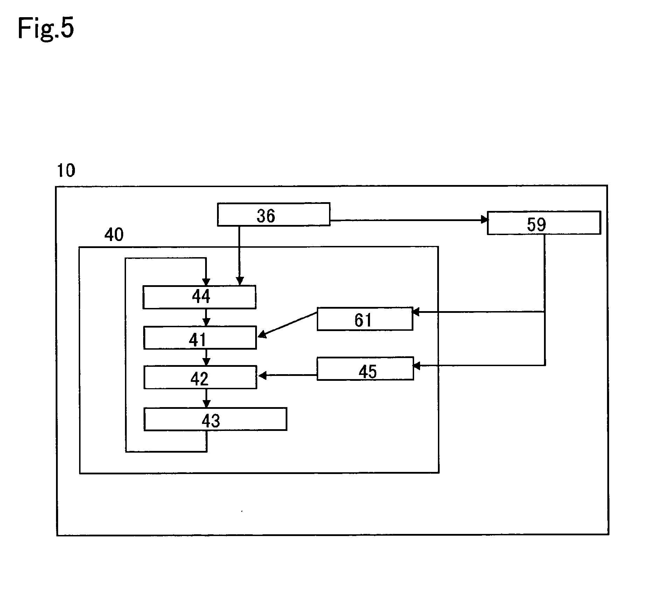

Fig. 1(A) is a graph showing a refrigeration cycle in which a cooling device according to an embodiment of the present invention is used; Fig. 1(B) is a view showing a state of heat radiation by a typical capillary tube; Fig. 1(C) is a view showing a state of heat radiation by a capillary tube according to the present invention; Fig. 2(A) is a perspective view showing a computer according to an embodiment of the present invention; Fig. 2(B) is a perspective view showing a cooling device to be incorporated in this computer; Fig. 3(A) is a perspective view showing a computer according to the embodiment of the present invention; Fig. 3(B) is a perspective view showing a cooling device to be incorporated in this computer; Fig. 4(A) is a perspective view showing a computer according to the embodiment of the present invention; Fig. 4(B) is a perspective view showing the computer viewed from another angle; and Fig. 5 is a view showing an electrical configuration of a cooling device according to an embodiment of the present invention.

### BEST EMBODIMENTS FOR CARRYING OUT THE INVENTION

An embodiment of a cooling device according to the present invention will be described below with reference to the drawings.

### <FIRST EMBODIMENT>

First of all, a cooling capacity of a cooling device of this embodiment applying a refrigeration cycle will be described with reference to Figs. 1(A) to 1(C). Fig. 1(A) is a p-h diagram showing a refrigeration cycle of this embodiment and a typical refrigeration cycle, Fig. 1(B) is a view showing a state of heat radiation of a typical capillary tube, and Fig. 1(C) is a view showing a state of heat radiation of a capillary tube of this embodiment.

A difference between a refrigeration cycle L3 of the cooling device of this embodiment and a refrigeration cycle L4 of the typical refrigeration cycle will be described with reference to the graph in Fig. 1(A). The graph shown in this drawing is a p-h diagram showing a state of a refrigerant such as chlorofluorocarbon, in which a lateral axis indicates specific enthalpy (an amount of heat) contained in the refrigerant per unit weight while a longitudinal axis indicates pressure of the refrigerant.

In further description of this graph, a saturated liquid line L1 and a saturated vapor line L2 are indicated by chain dot lines. When the state of the refrigerant is located on the left side of the saturated liquid line L1, the refrigerant becomes a subcooled liquid. On the contrary, when the state of the refrigerant is located on the right side of the saturated liquid line L2, the refrigerant becomes a superheated vapor. Moreover, when the state of the refrigerant is located between the saturated liquid line and the saturated vapor line, the refrigerant becomes a wet vapor.

In this graph, the typical refrigeration cycle L4 and the refrigeration cycle L3 of this embodiment are indicated by solid lines. Moreover, an outside atmosphere isothermal line L5 (for example, 35°C) is indicated by a bold dotted line.

In the typical refrigeration cycle L4 used for a refrigerator, the temperature inside the refrigerator is maintained at about 0°C, for example, by repeating evaporation, compression, condensation, and expansion of the refrigerant. Meanwhile, as described above, it was understood that the expansion executed by use of a capillary tube, an expansion valve, or the like is generally performed in a state where there is no access of heat to and from the outside. Moreover, even when the heat exchange with the outside takes place in the expansion process, such an amount of heat is fractional and is therefore ignored. In this embodiment, the heat is actively radiated from the capillary tube in order to enhance the cooling capacity of the cooling device.

Further, part of the typical refrigeration cycle L4 is located below the outside atmosphere isothermal line L5. This shows that, in the refrigeration cycle, the temperature of the refrigerant becomes temporarily lower than the outside atmosphere and then the refrigerant absorbs the heat from the outside atmosphere so that cooling efficiency is degraded. This feature will be described below with reference to Fig. 1(B).

Referring to the graph in Fig. 1(A), the P-h diagram of the refrigeration cycle L3 of this embodiment is located above the P-h diagram of the typical refrigeration diagram L4. Specifically, in the refrigeration cycle L3 of this embodiment, processes of evaporation, compression, condensation, and expansion the refrigerant are executed in a state of higher temperature of the refrigerant as compared to the typical cycle. To be more precise, in the refrigeration cycle of this embodiment, the temperature of the refrigerant in the evaporation process (i.e. the temperature of the refrigerant at the end of the expansion process) is higher than the outside atmosphere.

Therefore, in this embodiment, it is possible to radiate thermal energy contained in the refrigerant from the entire capillary tube to the external atmosphere and thereby to enhance the cooling capacity of the cooling device. With reference to Fig. 1(A), the cooling capacity is enhanced by an amount equivalent to an inclination in the expansion process. Here, the enthalpy reduced in the expansion process is indicated by Δh. While this Δh is, for example, approximately equal to several watts, it is possible to enhance the cooling capacity by several percent in a case where the cooling device is a small one to be provided in a notebook personal computer or the like and the cooling capacity is as small as 100 W, for example. Alternatively, in the case where the cooling capacity of the approximately same level is achieved with Δh taken into consideration, the capacity of the condenser to perform condensation can be reduced to have a smaller size thereof.

Next, the heat radiation of a typical capillary tube 143 described above will be explained again with reference to Fig. 1(B). Since the cooling device including the refrigeration cycle is generally used for a refrigerator or a freezer, the temperature of the refrigerant is set to be low. For example, the temperature of the refrigerant to be introduced to the capillary tube 143 is around 30°C and the temperature of the refrigerant to be discharged from the capillary tube 143 is around 10°C. Concerning the refrigerant passing through the capillary tube 143, the pressure is reduced and the temperature is lowered from 30°C to 10°C. Therefore, when the temperature of the outside atmosphere is 20°C, for example, the heat is radiated from the refrigerant to the outside ahead of a certain point of the capillary tube 143, and then the heat is absorbed from the outside to the refrigerant behind the certain point of the capillary 143. From this fact, a conventional cooling device is not expected to have an improved capacity of cooling with a capillary tube. On the other hand, if the outside atmosphere has a high temperature, there is a risk that the refrigerant absorbs the heat inside the capillary tube 143 so that the cooling capacity of the cooling device is degraded. Otherwise, even if the heat is radiated with the capillary tube 143 and the cooling capacity is enhanced by several watts, the contribution of the capillary tube 143 to the cooling capacity is small because the cooling capacity of a typical refrigerator is as extremely large as several hundred watts.

With reference to Fig. 1(C), in this embodiment, the temperature of the contained refrigerant is higher than the temperature of the outside atmosphere (20°C to 40°C) in an entire region of a capillary tube 43. In other words, the heat is radiated from the entire region of the capillary tube 43 to the outside atmosphere. To be more precise, for example, the temperature of the refrigerant to be introduced to an inlet of the capillary tube 43 is 40°C to 80°C, and the temperature of the refrigerant to be radiated from an outlet of the capillary tube 43 is about 20°C to 60°C.

The cooling device of this embodiment is used for cooling a semiconductor element (an exothermic body) such as a CPU which eventually has a high temperature of around 100°C or above, for example, after the semiconductor element is left to stand. Therefore, in comparison with the refrigerator to cool the air down to the temperature around 0°C, the temperature of the object to be cooled differs by 100°C or more. From this fact, it is possible to raise the temperature of the refrigerant easily and to increase a radiation effect of the capillary tube 43.

The simplest method of enhancing the cooling capacity of the cooling device applying the refrigeration cycle is to increase the size of a condenser, and the cooling capacity is enhanced by this method for a refrigerator or the like. The cooling device of this embodiment is housed in a notebook personal computer or the like in some cases. Accordingly, the size of the condenser is not easy to increase. From this point, in this embodiment, the enthalpy of the refrigerant is reduced by radiation from the capillary tube so that an increase in the size of the entire device is suppressed and the cooling capacity of the cooling device is enhanced.

### <SECOND EMBODIMENT>

With reference to Figs. 2 (A) to Fig. 4(B), configurations of a computer as an example of a device applying the above-described cooling device will be explained in this embodiment. In this embodiment, a notebook computer or a desktop computer will be mainly described as an embodiment of the electronic device. However, the cooling device of this embodiment is also applicable to other devices. For example, this embodiment is also applicable to a PDA (personal digital assistance) and the like.

Figs. 2 (A) and 2 (B) are views showing a desktop computer 10 (hereinafter abbreviated as the computer 10) of this embodiment. Fig. 2 (A) is a perspective view of the computer viewed from above and Fig. 2 (B) is a perspective view showing a cooling device 40 incorporated in the computer 10. Although only a casing unit 30 of the computer 10 is illustrated therein, in addition to this, the computer 10 is also equipped with a display, a mouse (a pointing device), a keyboard, and the like.

With reference to Fig. 2(A), a function element (an exothermic body), such as a CPU 36, that is accompanied with heat generation and the cooling device 40 having a function to cool this CPU 36 are incorporated in the casing unit 30 of the computer 10 of this embodiment.

To be more precise, a motherboard 31, a CD (compact disc) ROM drive 32, a FDD (floppy disk drive) 35, the cooling device 40, the CPU 36, and the like are incorporated in the casing unit 30. Moreover, in addition to these, although illustration is omitted herein, a battery, a HDD (hard disk drive), a PC card reader, a semiconductor memory, cables for connecting these items to one another, and the like are incorporated in the casing unit 30. Further, these electronic components incorporated in the casing unit 30 are disposed in different positions on the plane. Among the electronic components incorporated in the casing unit 30, the CPU 36 generates a particularly high amount of heat. The cooling device 40 is provided to execute radiation of this CPU 36.

A configuration of the cooling device 40 will be described with reference to Fig. 2(B). The cooling device 40 includes a compressor 41 (compressing means), a condenser 42 (condensing means), an evaporator 44 (evaporating means), a capillary tube 43 (expanding means), and an air blow fan 45 (air blowing means). Moreover, these devices constituting the cooling device 40 are connected to one another through tube-shaped pipes 46.

The compressor 41 has a function to compress the introduced refrigerant made of ammonia, chlorofluorocarbon, carbon dioxide, or the like. A rotary compressor (rotary type) or a reciprocating compressor (reciprocating type) is employed as the compressor 41.

The condenser 42 has functions to radiate the heat from the refrigerant compressed by the compressor 41 to the outside and to condense and liquefy the refrigerant. Moreover, the condenser 42 is formed by multiple metal plates disposed mutually in parallel. In addition, the metal plates constituting the condenser 42 are thermally coupled with the pipe 46 where the refrigerant passes through.

The capillary tube 43 has a function to expand the refrigerant. Here, the capillary tube 43 is rolled up into a circle and disposed above the air blow fan 45. By disposing the capillary tube 43 above the air blow fan 45, it is possible to reduce a planar size of the cooling device 40.

Moreover, the capillary tube 43 is disposed between a pipe 46D thermally coupled with the condenser 42 and a pipe 46E connected to the evaporator 44. Similar to the pipe 46E and others, the capillary tube 43 is a tube-shaped component made of a metal material such as copper. Further, the capillary tube 43 is formed to have a thinner diameter than other pipes so that a pressure loss is generated, thereby functioning as the expanding means. For example an outside diameter of the pipe 46E and the like is equal to 3.2 mm while an outside diameter of the capillary tube 43 is around 1.6 mm. Meanwhile, the length of the capillary tube 43 is in a range from about 30 cm to 50 cm, for example.

The evaporator 44 is thermally coupled with the electronic component such as the CPU 36, that is accompanied with heat generation. Therefore, receiving the heat generated from the CPU 36 by the evaporator 44 causes the refrigerant to change from a liquid state to a gas state inside the evaporator 44. Here, the evaporator 44 is disposed in a position where the CPU 36 is superposed.

The air blow fan 45 has functions to take low-temperature (room-temperature) air from the outside of the casing unit 30 and to blow this low-temperature air to the condenser 42 and the compressor 41. The air heated to a high temperature by receiving the heat from the condenser 42 and the compressor 41 is radiated from a side section of the casing 30 to the outside.

Operations of the cooling device 40 having the above-described configuration are as follows. When the cooling device 40 is started for cooling the CPU 36 or the like, the refrigerant firstly becomes in a high-temperature and high-pressure state by the compressor 41. The refrigerant in the high-temperature and high-pressure state is sent to the condenser 42 through the pipe 46. In the condenser 42, the refrigerant is liquefied by a cooling function of the low-temperature air sent from the air blow fan 45. The refrigerant in the liquid state is sent to the capillary tube 43 through the pipe 46. In the capillary tube 43, the refrigerant is expanded and becomes in a low-pressure and low-temperature state, and this refrigerant is sent to the evaporator 44. In the evaporator 44, the heat generated from the CPU 36 is received by the refrigerant. As a result, the refrigerant is evaporated and becomes in a gas state, and this refrigerant in the gas state is sent to the compressor 41 again.

The cooling device 40 operates as described above so that the CPU 36 is cooled. In this embodiment, by employing the cooling device 40 of a refrigeration system, it is possible to sufficiently cool the CPU 36 that has power consumption in a range from about 60 W to 200 W, for example.

The schematic configuration of the computer 10 including the cooling device 40 has been described above. Here, the CPU 36 is employed as the exothermic body to be cooled by the cooling device 40. However, it is also possible to employ a component other than the CPU as the exothermic body. For example, it is possible to employ a semiconductor memory, a resistor, a unit for controlling a liquid crystal display, a power unit, an inverter, and the like as the exothermic body to be cooled by the cooling device 40.

In this embodiment, part of the capillary tube 43 corresponding to the expanding means is disposed so as to abut on a casing of the air blow fan 45. Here, the part of the capillary tube 43 is laid out helically or spirally so as to abut on an upper face of the casing of the air blow fan 45. Arranging this way enables heat conduction (thermal diffusion) from the capillary tube 43 to the air blow fan 45. The material for forming the casing of the air blow fan 45 may be a resin material or a metal material. In particular, by employing a metal material having an excellent heat conductivity (such as aluminum), it is possible to further enhance a radiation effect of the capillary tube 43.

To be more precise, since the air blow fan 45 constantly takes in the outside air, the casing of the air blow fan 45 has substantially the same temperature (around 30°C, for example) as the outside air. Meanwhile, the temperature of the refrigerant flowing inside the capillary tube 43 is in a range from 90°C to 50°C, for example, which is higher than the temperature of the outside air. That is, the temperature of the casing of the air blow fan 45 is lower than the capillary tube 43. Therefore, by bringing the capillary tube 43 into contact with the casing of the air blow fan 45, the heat is conducted from the capillary tube 43 to the air blow fan 45. Hence it is possible to enhance the radiation effect of the capillary tube 43.

In the drawing, an aperture for taking air inside the personal computer is provided in the vicinity of a central part on the upper face of the casing of the air blow fan 45. Therefore, it is not advisable to allow the capillary tube 43 to abut on a position in the vicinity of the central part on the upper face of the casing of the air blow fan 45. Here, the area of contact between the air blow fan 45 and the capillary tube 43 is increased by disposing the capillary tube 43 spirally along a peripheral part on the upper face of the casing of the air blow fan 45.

Moreover, in this embodiment, it is also possible to allow part of the capillary tube 43 to abut on an inner wall of the casing unit 30. Since an outer face of the casing unit 30 contacts the outside air, an inner face thereof has a low temperature which is substantially the same temperature as the outside air. Moreover, the casing unit 30 is made of the metal having an excellent heat conductivity such as aluminum. Therefore, by allowing the capillary tube 43 to abut on the inner wall of the casing unit 30, the thermal energy contained in the refrigerant flowing inside the capillary tube 43 is conducted to the casing unit 30 so that the refrigerant is cooled.

Furthermore, by allowing the capillary tube 43 to abut on both of the air blow fan 45 and the casing unit 30, it is possible to further increase the effect of cooling the refrigerant inside the capillary tube 43.

Next, another structure for actively radiating the heat from a capillary tube 43 by forced convection will be described with reference to Figs. 3(A) and 3(B). Fig. 3 (A) is a perspective view of the computer 10 and Fig. 3 (B) is an enlarged perspective view showing a portion where a cooling device 40 is provided. Here, at least one portion of the capillary tube 43 is disposed in a region where an air blow fan 45 blows the air. In this way, it is possible to further increase the effect of radiation from the capillary tube 43 by the effect of forced convection.

The air blow fan 45 has functions to take the outside air from the outside of the casing unit 30 of the computer 10 (from a bottom face of the casing unit 30 in this case) and to blow the air flow to the condenser 42 and the compressor 41 which are radiating bodies. Here, the air blowed onto the condenser 42 and heated to a high temperature is radiated from an exhaust vent 38 to the outside. Besides, the air blowed onto the compressor 41 is radiated from an exhaust vent 37 to the outside.

Part of the capillary tube 43 extends between the air blow fan 45 and the compressor 41. Moreover, the capillary tube 43 is wound into a coil shape (a spiral shape) and disposed in the vicinity of the air blow fan 45. Therefore, it is possible to have the increased length of the capillary tube 43 to which the air is blowed by the air blow fan 45.

In this embodiment, the compressor 41 is disposed apart from the air blow fan 45. The reason is that, if the compressor 41 and the air blow fan 45 are disposed close to each other, an outlet of the air flow from the air blow fan 45 is blocked by the compressor 41 so that the compressor 41 is not sufficiently cooled. Here, the capillary tube 43 is disposed between the compressor 41 and the air blow fan 45. Accordingly, it is possible to use an open region between the compressor 41 and the air blow fan 45 as a region for cooling the capillary tube 43. This contributes to decreasing the size of the entire cooling device 40.

The region where the capillary tube 43 is wound and disposed may also be located in a position other than the above-described region. For example, it is also possible to dispose the capillary tube 43 between the compressor 41 and the exhaust vent 37. Moreover, the capillary tube 43 may also be disposed between the condenser 42 and the air blow fan 45 or between the condenser 42 and the exhaust vent 38.

Here, it is also possible to combine the structure of the capillary tube 43 shown in Figs. 2(A) and 2(B) and the structure of the capillary tube 43 shown in Figs. 3 (A) and 3 (B) . Specifically, part of the capillary tube 43 is allowed to abut on the air blow fan 45 or the casing unit 30 and part of the capillary tube 43 is disposed in the position where the air blow fan 45 blows the air. This enables further enhancement of the function to cool the refrigerant inside the capillary tube 43 so that the cooling capacity of the cooling device 40 is further increased.

Next, a case where the above-described configuration is applied to a notebook computer 10 will be described with reference to Figs. 4(A) and 4(B). Fig. 4(A) is a perspective view showing the notebook computer 10 and Fig. 4(B) is a perspective view showing a state of the notebook computer 10 viewed from below. Incidentally, in Fig. 4(B), L means a left side, R means a right side, F means a front side, and B means a back side.

With reference to Fig. 4(A), the notebook computer 10 includes a casing unit 30 incorporating an element accompanied with heat generation such as a CPU 36 and a display unit 20 to be rotatably connected to the casing unit 30.

The display unit 20 includes a display such as a liquid crystal display or an organic EL (electro-luminescence) display.

The planar sizes of the display unit 20 and of the casing unit 30 are substantially the same. The display unit 20 and the casing unit 30 are folded into a single casing as a whole. The planar size of the computer 10 in the state of folding the casing unit 30 and the display unit 20 is equal to the A4 size (210 mm x 290 mm) or the B5 size (182 mm x 257 mm). Moreover, although illustration is omitted herein, a keyboard or a pointing device such as a pad is disposed on the upper surface of the casing unit 30.

With reference to Fig. 4(B), an air blow fan 45 takes low-temperature air of the outside into the casing unit 30 through an intake vent 39 provided on the bottom face of the casing unit 30. Moreover, the high temperature air caused by cooling a capillary tube 43, a condenser 42, and a compressor 41 is radiated to the outside through exhaust vents 37 and 38 provided on side sections of the casing unit 30. In the intake vent 39 and the exhaust vents 37 and 38, numerous holes in slit shapes are provided on the casing unit 30.

By providing the exhaust bent 38 on the back side B of the casing unit 30, high temperature air heated by receiving the heat from the condenser 42 and the capillary tube 43 is radiated to the back side B of the computer 10. Accordingly, the heated air is not radiated toward a user located on the front side F of the computer 10, and it is therefore possible to prevent the user from being got injured, including a burn or the like. Alternatively, the air heated to the high temperature by receiving the heat from the condenser 42 may be radiated to the outside from a right side section R or a left side section L of the casing unit 30.

Moreover, by providing the exhaust vent 37 on the left side L of the casing unit 30, the high temperature air caused by cooling the compressor 41 is radiated from the left side L of the computer 10 to the outside. A general user operates a pointing device such as a mouse with the right hand. Therefore, the high-temperature air radiated from the exhaust vent 37 does not touch the hand of the user using the mouse. Accordingly, it is possible to prevent the user from being got burned. Alternatively, the exhaust vent 37 may be provided on the right side R of the casing unit 30.

### <THIRD EMBODIMENT>

Description will be given of operations of a computer 10, focused on a cooling action of a CPU 36 with reference to Fig. 5. Here, a microcomputer 59 controls rotation of a compressor 41 and an air blow fan 45 based on temperature information of the CPU 36. This causes the revolutions of the air blow fan 45 and a compressor 41 to differ between the case of a low temperature and the case of a high temperature of the CPU 36.

To be more precise, as described above, the heat generated from the function element such as the CPU 36 is received by the refrigerant through an evaporator 44 of a cooling device 40. Then, inside the cooling device 40, the refrigerant is circulated among the evaporator 44, the compressor 41, a condenser 42, and a capillary tube 43, with expansion and compression repeated. Moreover, in this embodiment, the thermal energy contained in the refrigerant is radiated to the outside, also when the refrigerant flows inside the capillary tube 43. Meanwhile, the air blow fan 45 blows the air onto the condenser 42 and the capillary tube 43 and thereby the heat of the refrigerant is radiated to the outside. Furthermore, a motor incorporated in the compressor 41 is controlled by an inverter 61.

According to the above-described configuration of this embodiment, it is possible to maintain the temperature of the CPU 36 equal to or below a certain level (for example, equal to or below 70°C). However, the amount of heat generated by the CPU 36 is not constant. Specifically, the amount of generated heat is increased when the CPU 36 is actively operated, while the amount of generated heat is decreased when the CPU 36 is not actively operated. From this point, if the rotating speeds of the motor included in the compressor 41 and of the air blow fan 45 are low, there is a risk of an increase in temperature of the CPU 36 when a temporary increase in the amount of heat generated by the CPU 36 causes insufficient cooling capacity of the cooling device 40. On the contrary, it is possible to suppress a rise in temperature of the CPU 36 by setting constant high rotating speeds of the motor included in the compressor 41 and of the air blow fan 45 in order to prevent this phenomenon. However, there is a risk of an increase in power consumed by the cooling device 40.

Therefore, in this embodiment, the rotating speeds of the motor included in the compressor 41 and of the air blow fan 45 are controlled in accordance with the temperature of the CPU 36. Specifically, as the temperature of the CPU 36 becomes higher, the rotating speeds thereof are accelerated. In this way, it is possible to maintain the temperature of the CPU 36 in a range from 50°C to 70°C, for example. The details are as follows.

The temperature of the CPU 36 is monitored by a sensor unit (monitoring means) incorporated in the CPU 36 itself and the temperature information indicating the temperature of the CPU 36 is sent to the microcomputer 59 (controlling means). The microcomputer 59 controls the revolutions of the inverter 61 and the air blow fan 45.

For example, in the case of an attempt to maintain the temperature in the range from 50°C to 70°C as described above, the microcomputer 59 controls the revolutions of the inverter 61 and the air blow fan 45 as follows.

When the temperature of the CPU 36 is below 55°C (first temperature), the revolutions of the inverter 61 and the air blow fan 45 are maintained constant based on an instruction of the microcomputer 59. The revolutions at this time are equivalent to the revolutions at which operations are allowed within a silent range for operation sounds generated from the air blow fan 45 and the compressor 41.

When the temperature of the CPU 36 is in a range from 55°C to 65°C, the revolutions of the inverter 61 and the air blow fan 45 are increased in proportion to the rise in temperature of the CPU 36. In this way, the cooling capacity of the cooling device 40 is adjusted within a range from 55°C to 65°C, according to the temperature change of the CPU 36. Accordingly, the temperature of the CPU 36 can be controlled to stay in the range from 50°C to 70°C as described above.

When the temperature of the CPU 36 is equal to or above 65°C (second temperature), the revolutions of the inverter 61 and the air blow fan 45 are maintained constant. That is, the motors included in the compressor 41 and in the air blow fan 45 are rotated at the maximum revolutions. In this way, it is possible to suppress the rise in temperature of the CPU 36.

These are the description of the operations of the computer 10 for cooling the CPU 36.

## Claims

1. A cooling device comprising:
compressing means for compressing a refrigerant;
condensing means for radiating heat from the refrigerant compressed by the compressing means to outside to liquefy the refrigerant;
expanding means for expanding the refrigerant liquefied by the condensing means; and
evaporating means for evaporating the refrigerant which is expanded by the expanding means and receives heat from an exothermic body, wherein
thermal energy contained in the refrigerant is radiated from an entire region of the expanding means to the outside.

2. The cooling device according to claim 1, wherein
the expanding means is a capillary tube.

3. The cooling device according to claim 1, wherein
temperature of the refrigerant to be introduced from the expanding means to the evaporating means is higher than that of outside atmosphere surrounding the expanding means.

4. The cooling device according to claim 1, wherein
temperature of the refrigerant incorporated in an entire section of the expanding means is higher than that of outside atmosphere surrounding the expanding means.

5. The cooling device according to claim 1, wherein
the expanding means is allowed to contact any of air blowing means and a casing of an electronic device to radiate thermal energy from the expanding means to the outside by thermal diffusion.

6. The cooling device according to claim 1, wherein
at least one portion of the expanding means is disposed in a region where air flow generated by air blowing means passes through to radiate thermal energy from the expanding means to the outside by forced convection.

7. The cooling device according to claim 6, wherein
the air blowing means blows air to the condensing means and/or the compressing means.

## Amended claims

### Amended claims under Art. 19.1 PCT

1. (Amended) A cooling device to be used in an electronic device comprising:
compressing means for compressing a refrigerant;
condensing means for radiating heat from the refrigerant compressed by the compressing means and to liquefy the refrigerant;
expanding means for expanding the refrigerant liquefied by the condensing means; and
evaporating means for evaporating the refrigerant which is expanded by the expanding means and receives heat from an exothermic body, wherein
thermal energy contained in the refrigerant is radiated from an entire region of the expanding means to any of ambient air around the electronic device and air inside the electronic device.

2. (Amended) The cooling device to be used in an electronic device according to claim 1, wherein
the expanding means is a capillary tube.

3. (Amended) The cooling device to be used in an electronic device according to claim 1, wherein
temperature of the refrigerant to be introduced from the expanding means to the evaporating means is higher than that of outside atmosphere surrounding the expanding means.

4. (Amended) The cooling device to be used in an electronic device according to claim 1, wherein
temperature of the refrigerant incorporated in an entire section of the expanding means is higher than that of outside atmosphere surrounding the expanding means.

5. (Amended) The cooling device to be used in an electronic device according to claim 1, wherein
the expanding means is allowed to contact any of air blowing means and a casing of an electronic device to radiate thermal energy from the expanding means to any of the ambient air around the electronic device and the air inside the electronic device by thermal diffusion.

6. (Amended) The cooling device to be used in an electronic device according to claim 1, wherein
at least one portion of the expanding means is disposed in a region where wind generated by air blowing means passes through to radiate thermal energy from the expanding means to any of the ambient air around the electronic device and the air inside the electronic device by forced convection.

7. (Amended) The cooling device to be used in an electronic device according to claim 6, wherein
the air blowing means blows air to the condensing means and/or the compressing means.

Statement under Art. 19.1 PCT
In claims 1, 5, and 6, the description "outside" is amended as "any of ambient (the) air around the electronic device and (the) air inside the electronic device".

Moreover, in all claims, the description "cooling device" is amended as "cooling device to be used in an electronic device".

There are the descriptions, quote:

"Document 2 discloses a heat pump type drying machine comprising a compressor for compressing a refrigerant, a radiator for radiating the refrigerant, a capillary tube for expanding refrigerant, and an evaporator for evaporating the refrigerant, wherein the capillary tube performs heat exchange by using an auxiliary heat exchanger for enhancement of a cooling capacity of the evaporator and for energy saving"; and

"The invention according to claims 1 to 4 of the present application does not possesses an inventive step over Documents 1 and 2 cited in the international search report. It is easy for those skilled in the art that the technique disclosed in Document 2 pertaining, as air-conditioning equipment, to the identical technical classification is applied to the cooling system disclosed in Document 1 in order to enhance a cooling capacity of the evaporator and to reduce energy consumption.", unquote.

Nevertheless, Document 2 is **characterized by** "the configuration to cause the refrigerant between the outlet of the radiator and the outlet of the expansion mechanism to exchange the heat with the refrigerant between the outlet of the evaporator and the inlet of the compressor". In the configuration, the heat is exchanged inside its own refrigerant circuit. Moreover, the temperature of "the refrigerant between the refrigerant outlet of the radiator and the refrigerant outlet of the expansion mechanism" is not necessarily higher over the entire section than the temperature of "the refrigerant between the refrigerant outlet of the evaporator and the refrigerant inlet of the compressor." Therefore, it cannot be concluded that this configuration is an effective measure for reducing energy consumption.

On the other hand, the present invention is **characterized by** performing the heat exchange with the outside atmosphere and by performing the heat exchange effectively by utilizing the fact that the temperature of the refrigerant over the entire section of expansion is higher than the temperature of the outside atmosphere.

Here, the outside and the outside atmosphere indicate factors other than the refrigerant, which include ambient air around an electronic device, air inside the electronic device, a casing of the electronic device having a similar temperature, and a casing of an elemental component of the electronic device such as a fan casing.

From these points of view, we consider that the present invention possesses the inventive step.
